# EUROPEAN PATENT APPLICATION

(11) **EP 1 850 168 A2**
(43) Date of publication of application: **31.10.2007**
(21) Application number: 07251678.4
(22) Date of filing: 23.04.2007
(51) Int. Cl.: G02F 1/13, G09F 9/00, H01R 31/06

(54) **Substrate mounting method, display device and substrate**

(30) Priority: 24.04.2006 JP 2006119675
(71) Applicant: ORION ELECTRIC CO., Ltd., Fukui 915-8555 (JP)
(72) Inventor: Kakiuchi, Atsushi, Echizen city Fukui 915-8555 (JP)
(74) Representative: Paget, Hugh Charles Edward

(57) **Abstract**

The present invention provide a substrate mounting method, a display device and a substrate for realizing sharing of the substrate without increasing the number of substrates. A substrate 21 provided with through holes through which pins of a wire member connector are passed at an end for mounting the wire member connector and lands 55 for mounting a board-to-board connector by soldering pins of the board-to-board connector to the vicinity of the through holes on a surface opposite to the surface on which the wire member connector is mounted, wherein the pins of the wire member connector are passed through the through holes and the pins of the wire member connector and the corresponding lands 55 are electrically connected using conductive wires 57.

## Description

### BACKGROUND OF THE INVENTION

### Field of the Invention

The present invention relates to a display device, a substrate mounted in the display device and a method of mounting the substrate in the display device, and more particularly, to a display device such as a liquid crystal display and a plasma display, a substrate mounted inside these display devices and a method of mounting the substrate inside these display devices.

### Description of the Related Art

Display devices such as liquid crystal displays and plasma displays in various sizes are currently on a manufacturing line and on the market. Such a display device is composed of a display section which displays videos, a plurality of substrates mounted on a panel provided inside the display device and an enclosure or the like. Each substrate is mounted with a plurality of electronic parts and these electronic parts realize various functions.

As for electronic parts used for a display device, some electronic parts differ depending on the size of the display device and others are commonly used regardless of the size of the display device. For example, electronic parts related to a power supply differ depending on the size of the display device because power used changes depending on the size of the display device. On the other hand, electronic parts which perform digital signal processing such as a digital tuner and MPEG-IC have common functions regardless of the size of the display device, and therefore the same electronic parts can be used regardless of the size of the display device.

Japanese Patent Laid-Open Publication No. 2003-173150 (Patent Document 1) discloses a technique whereby electronic parts which can be used commonly irrespective of the size of a display device are gathered on one substrate and this substrate is commonly used regardless of the size of the display device. According to this technique, since electronic parts which perform digital signal processing such as a digital tuner and MPEG-IC have common required functions regardless of the size of the display device, the substrate gathering these electronic parts can be used as a common substrate. This can simplify the design and realize sharing of electronic parts.

The substrate of a display device is mounted in a panel provided inside the display device. A small display device cannot use a large panel. Therefore, a method of mounting several substrates is used whereby the substrates are mounted superimposed one atop another using a board-to-board connector. The substrates are electrically and physically inter-connected using this board-to-board connector.

On the other hand, a large display device can use a large panel and does not use any board-to-board connector, directly mount each substrate on the panel, and can thereby slim down the display device. Furthermore, electrical connections are realized by mounting wire member connectors on the substrate and connecting the wire member connectors together using a flexible wiring board. That is, the method of mounting the substrate differs depending on the size of the display device.

When using the technique disclosed in Patent Document 1, two kinds of output position conversion substrates must be manufactured. That is, one is an output position conversion substrate for board-to-board connector connection when the display device is small and the other is an output position conversion substrate for a wire member connector when the display device is large. Therefore, there is a problem that the number of substrates to be mounted increases and that the number of substrate mounting processes increases.

### SUMMARY OF THE INVENTION

The present invention has been implemented in view of the above described problem and it is an object of the present invention to provide a substrate mounting method, a display device and a substrate capable of realizing sharing of substrates without increasing the number of substrates.

The substrate mounting method according to a first aspect is a substrate mounting method including the steps of electrically connecting a first substrate and a second substrate which is provided with through holes through which pins of a wire member connector are passed at an end for mounting the wire member connector and lands for mounting a board-to-board connector by soldering pins of the board-to-board connector to the vicinity of the through holes on a surface opposite to the surface on which the wire member connector is mounted and mounting the substrates on a display device, wherein whether to superimpose at least part of the first substrate on the second substrate or separate the first substrate from the second substrate is made selectable according to the size of the display device, and when superimposition of the first substrate on the second substrate is selected, the board-to-board connector is mounted on the first substrate and the second substrate respectively, the first substrate is mounted on the second substrate, and then the board-to-board connector of the second substrate is electrically and physically connected to the board-to-board connector of the first substrate and the second substrate is mounted in an enclosure in such a way that the first substrate and the second substrate are arranged parallel to each other and at least partially overlap each other, and when separation of the first substrate from the second substrate is selected, the wire member connector is mounted on the first substrate and the second substrate respectively, the pins of the wire member connector passed through the through holes formed in the second substrate and the lands formed in the second substrate are electrically connected using a conductive material, the wire member connector of the first substrate and the wire member connector of the second substrate are electrically connected via a flexible wiring board, and the first substrate and the second substrate are arranged side by side and mounted on the display device.

According to the substrate mounting method according to the first aspect, it is possible to make the second substrate adaptable to both the connection method using the board-to-board connector and the connection method using the wire member connector.

The substrate mounting method according to a second aspect is the substrate mounting method according to the first aspect, wherein an electronic part which performs digital signal processing is mounted on the second substrate.

According to the substrate mounting method according to the second aspect, it is possible to further make the second substrate mounted with an electronic part which performs digital signal processing adaptable to both the connection method using the board-to-board connector and the connection method using the wire member connector.

The display device according to a third aspect is a display device including a first substrate and a second substrate provided with through holes through which pins of a wire member connector are passed at an end for mounting the wire member connector and lands for mounting a board-to-board connector by soldering pins of the board-to-board connector to the vicinity of the through holes on a surface opposite to the surface on which the wire member connector is mounted, wherein the board-to-board connector is mounted on the first substrate and the second substrate respectively, the first substrate is directly mounted on the display device, the board-to-board connector of the second substrate is electrically and physically connected to the board-to-board connector of the first substrate, and the second substrate is mounted on the display device in such a way that the first substrate and the second substrate are arranged parallel to each other and at least partially overlap each other.

According to the display device according to the third aspect, it is possible to make the second substrate adaptable to the connection method using the board-to-board connector.

The display device according to a fourth aspect is a display device including a first substrate and a second substrate provided with through holes through which pins of a wire member connector are passed at an end for mounting the wire member connector and lands for mounting a board-to-board connector by soldering pins of the board-to-board connector to the vicinity of the through holes on a surface opposite to the surface on which the wire member connector is mounted, wherein the wire member connector is mounted on the first substrate and the second substrate respectively, the pins of the wire member connector passed through the through holes formed in the second substrate and the lands formed in the second substrate are electrically connected through a conductive material and the wire member connector of the first substrate and the wire member connector of the second substrate are electrically connected via a flexible wiring board, and the first substrate and the second substrate are arranged side by side and mounted on the display device.

According to the display device according to the fourth aspect, it is possible to make the second substrate adaptable to the connection method using the wire member connector.

The display device according to a fifth aspect is the display device according to the third or fourth aspect, wherein an electronic part which performs digital signal processing is mounted on the second substrate.

According to the display device according to the fifth aspect, it is possible to make the second substrate mounted with an electronic part which performs digital signal processing adaptable to the connection method using the board-to-board connector or the connection method using the wire member connector.

The substrate according to a sixth aspect is a substrate including through holes through which pins of a wire member connector are passed at an end for mounting the wire member connector and lands for mounting a board-to-board connector by soldering pins of the board-to-board connector to the vicinity of the through holes on a surface opposite to the surface on which the wire member connector is mounted, wherein the pins of the wire member connector are passed through the through holes and the pins of the wire member connector and the lands are electrically connected through a conductive material.

According to the substrate according to the sixth aspect, it is possible to make the second substrate adaptable to the connection method using the wire member connector.

The substrate according to a seventh aspect is the substrate according to the sixth aspect, wherein an electronic part which performs digital signal processing is mounted thereon.

According to the substrate according to the seventh aspect, it is possible to further make the second substrate mounted with an electronic part which performs digital signal processing adaptable to the connection method using the wire member connector.

According to the present invention, it is possible to provide a substrate mounting method for making a substrate adaptable to both the connection method using the board-to-board connector and the connection method using the wire member connector. This makes the substrate on which electronic parts to be shared are gathered adaptable to both connection methods without increasing the number of substrates and thereby allows this substrate to be shared regardless of the size of the display device. Moreover, according to the present invention, it is possible to provide a substrate mounting method for making the substrate mounted with an electronic part which performs digital signal processing adaptable to both the connection method using the board-to-board connector and the connection method using the wire member connector. This makes the substrate on which electronic parts which perform digital signal processing are gathered adaptable to both connection methods without increasing the number of substrates and thereby allows this substrate to be shared regardless of the size of the display device.

According to the present invention, it is possible to provide a display device which makes a substrate adaptable to the connection method using the board-to-board connector. Furthermore, according to the present invention it is possible to provide a display device which makes a substrate adaptable to the connection method using the wire member connector. This makes the substrate on which electronic parts to be shared are gathered adaptable to both connection methods without increasing the number of substrates and thereby allows this substrate to be shared regardless of the size of the display device. Moreover, according to the present invention, it is possible to provide a display device which makes the substrate mounted with an electronic part which performs digital signal processing adaptable to both the connection method using the board-to-board connector and the connection method using the wire member connector. This makes the substrate on which electronic parts which perform digital signal processing are gathered adaptable to both connection methods without increasing the number of substrates and thereby allows this substrate to be shared regardless of the size of the display device.

According to the present invention, it is possible to provide a substrate adaptable to the connection method using the wire member connector. This makes the substrate on which electronic parts to be shared are gathered adaptable to this connection method without increasing the number of substrates. Moreover, according to the present invention, it is possible to provide a substrate mounted with an electronic part which performs digital signal processing which is adaptable to the connection method using the wire member connector. This makes the substrate on which electronic parts which perform digital signal processing are gathered adaptable to this connection method without increasing the number of substrates.

### BRIEF DESCRIPTION OF THE DRAWINGS

FIG. 1 is a bottom view of a common substrate according to an embodiment of the present invention;
FIG. 2 is a top view of the common substrate according to the embodiment of the present invention;
FIG. 3 is a perspective view of the bottom face of the common substrate mounted with a board-to-board connector and electronic parts according to the embodiment of the present invention;
FIG. 4 is a perspective view of the top face of the common substrate mounted with the board-to-board connector and the electronic parts according to the embodiment of the present invention;
FIG. 5 is a perspective view of the bottom face of the common substrate mounted with a wire member connector and the electronic parts according to the embodiment of the present invention;
FIG. 6 is a perspective view of the top face of the common substrate mounted with the wire member connector and the electronic parts according to the embodiment of the present invention;
FIG. 7 is a plan view of the panel mounted with the common substrate according to the embodiment of the present invention;
FIG. 8 is a plan view of the panel mounted with the common substrate according to the embodiment of the present invention; and
FIG. 9 is an X-X cross-sectional view of FIG. 7.

### DETAILED DESCRIPTION OF THE PREFERRED EMBODIMENTS

An embodiment of the present invention will be explained with reference to the attached drawings. The following embodiment is not more than a specific example of the present invention and the present invention is by no means limited to the following embodiment.

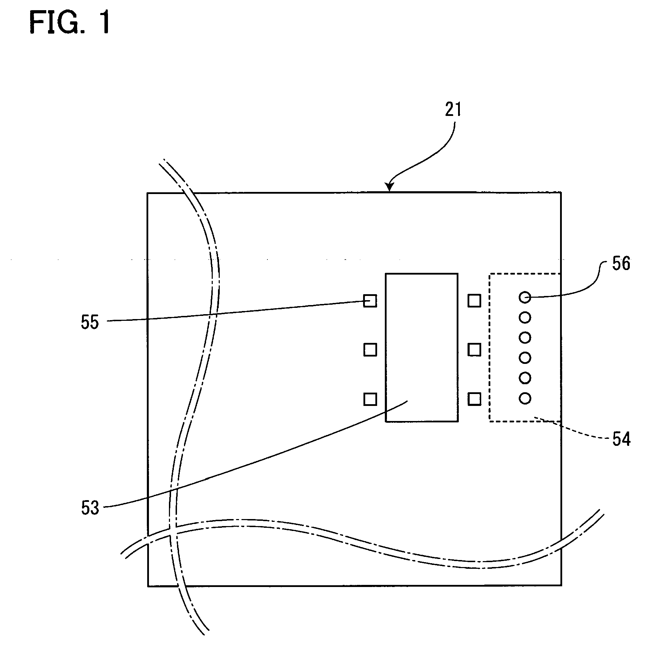

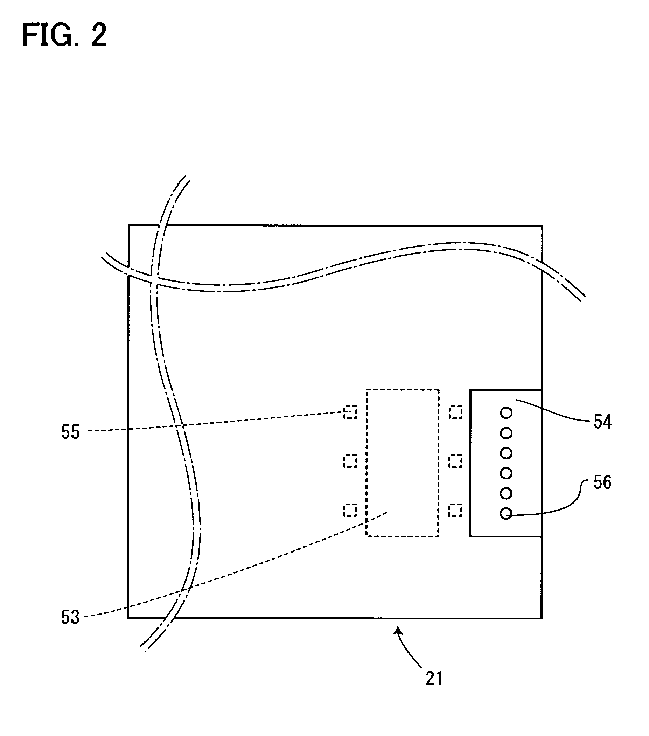

FIGS. 1 and 2 are a bottom view and a top view of a substrate according to this embodiment respectively. Here, this substrate corresponds to a second substrate according to aspects 1 to 5 and a substrate according to aspects 6 and 7 (hereinafter, referred to as a "common substrate"). Furthermore, suppose the surface facing a panel to be mounted, that is, the surface on the display section side is the bottom face and the surface opposite thereto is a top face. Through holes 56 are formed at an end of this common substrate 21 and lands 55 are formed in this neighborhood. The lands 55 are electrically connected to lands to which some electronic parts mounted on this common substrate 21 are soldered through a pattern.

On the bottom face of the common substrate shown in FIG. 1, a board-to-board connector can be mounted in a board-to-board connector mounting area 53 by soldering pins thereof to the land 55. On the top face of the common substrate shown in FIG. 2, a wire member connector can be mounted in a wire member connector mounting area 54 by passing pins thereof through the through holes 56. In the common substrate according to this embodiment, when the display device is smaller than a predetermined size, the board-to-board connector is mounted superimposed on another substrate, or otherwise a wire member connector is mounted and directly attached to the panel next to the other substrate.

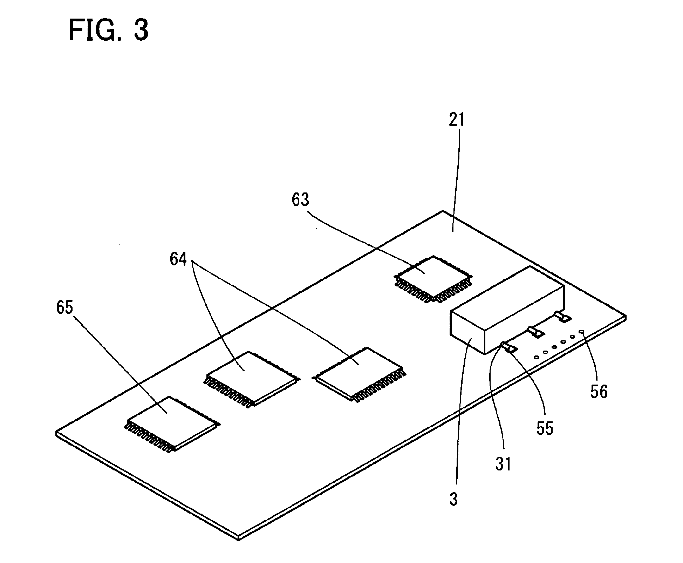

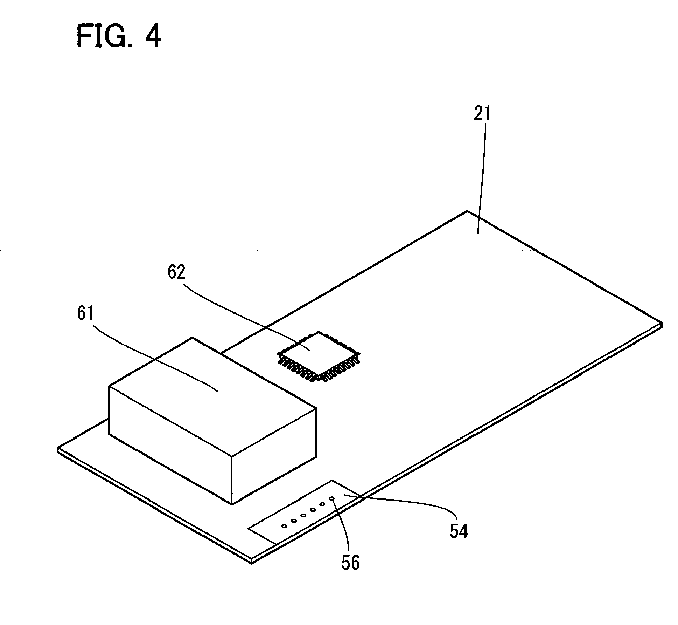

First, the case where the display device is smaller than the predetermined size, that is, a board-to-board connector is mounted on the common substrate superimposed on another substrate will be explained. FIGS. 3 and 4 show a bottom view and a top view of a common substrate 21 on which a board-to-board connector 3 and various electronic parts are mounted respectively.

Here, the board-to-board connector 3 is mounted by soldering pins 31 thereof and lands 55 together. Furthermore, a demodulation IC 63, SDRAMs 64 and a FLASH 65 are mounted on the bottom face of the common substrate 21 and a digital tuner 61 and an MPEG-IC 62 are mounted on the top face of the common substrate 21. These electronic parts are intended to perform digital signal processing and can be used commonly regardless of the size of the display device.

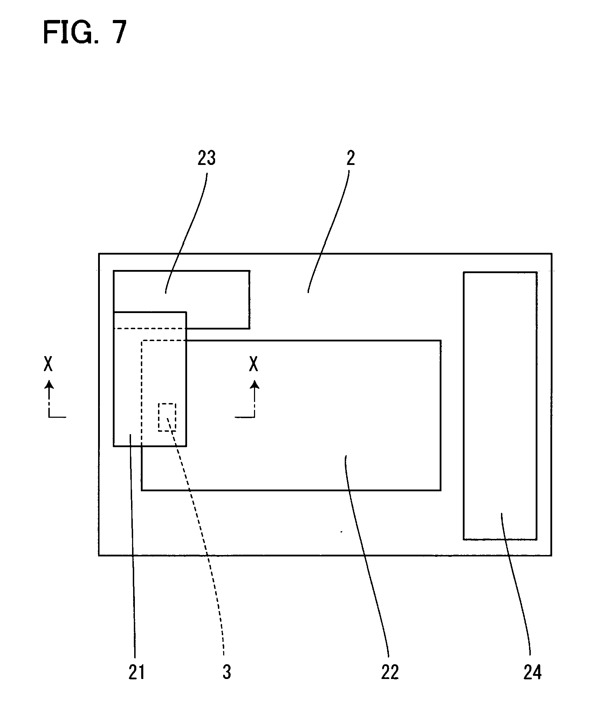

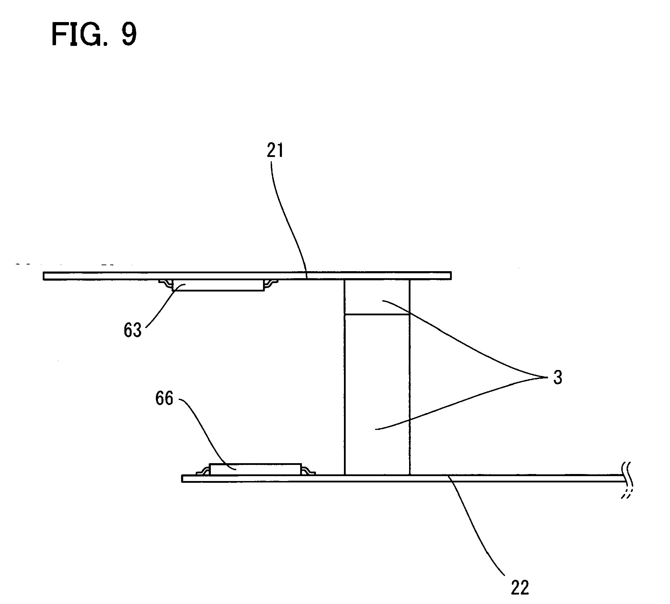

FIG. 7 is a plan view showing a panel inside the display device mounted with the common substrate 21 shown in FIG. 3 and FIG. 4, an AV/POWER substrate 22, a scaling substrate 23 and an inverter substrate 24 and FIG. 9 shows an X-X cross-sectional view of FIG. 7. Here, the AV/POWER substrate 22 is a substrate which carries out analog signal processing such as audio amplification, the scaling substrate 23 is a substrate which performs scaling of videos and the inverter substrate 24 is a substrate which converts an AC voltages supplied from outside to a DC voltage used for the display device. Furthermore, the AV/POWER substrate 22 is mounted with an IC 66 for carrying out analog signal processing. As shown in FIGS. 7 and 9, when the display device is small and only a small panel 2 can be used, the substrate is mounted superimposed on another substrate using the board-to-board connector 3.

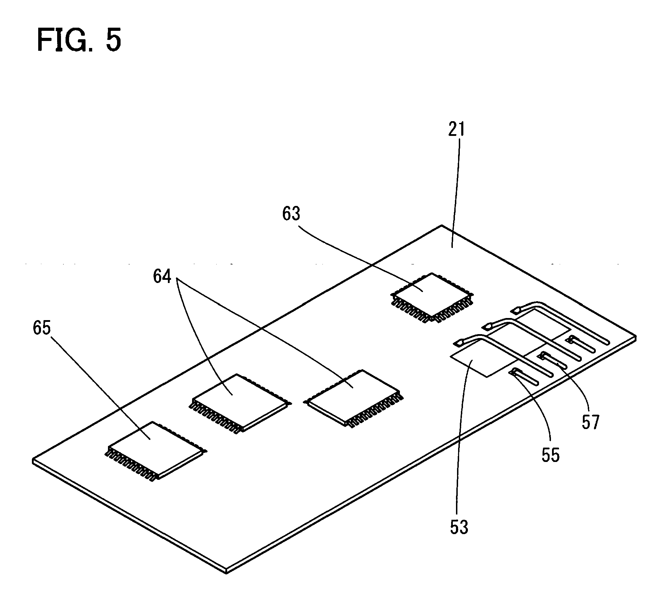

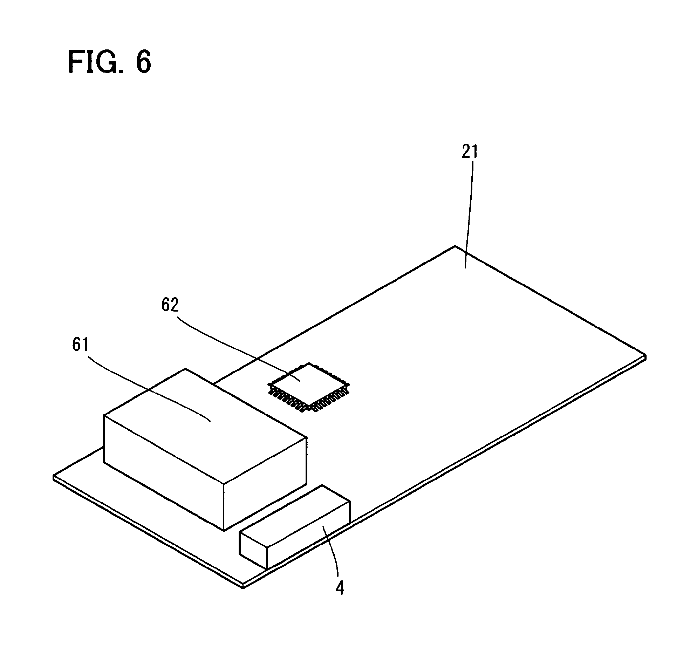

Next, the case where the display device is not smaller than a predetermined size, that is, the case where a wire member connector is mounted on the common substrate and directly attached to the panel next to another substrates will be explained. FIGS. 5 and 6 show a bottom view and a top view of the common substrate 21 mounted with a wire member connector 4 and various electronic parts respectively.

Here, the wire member connector 4 is mounted by passing pins thereof through the through holes and the pins which have passed through the through holes and lands 55 are electrically connected by conductive wires 57. Furthermore, a demodulation IC 63, SDRAMs 64 and a FLASH 65 are mounted on the bottom face of the common substrate 21, and a digital tuner 61 and an MPEG-IC 62 are mounted on the top face of the common substrate 21. These electronic parts are intended to perform digital signal processing and can be used commonly regardless of the size of the display device.

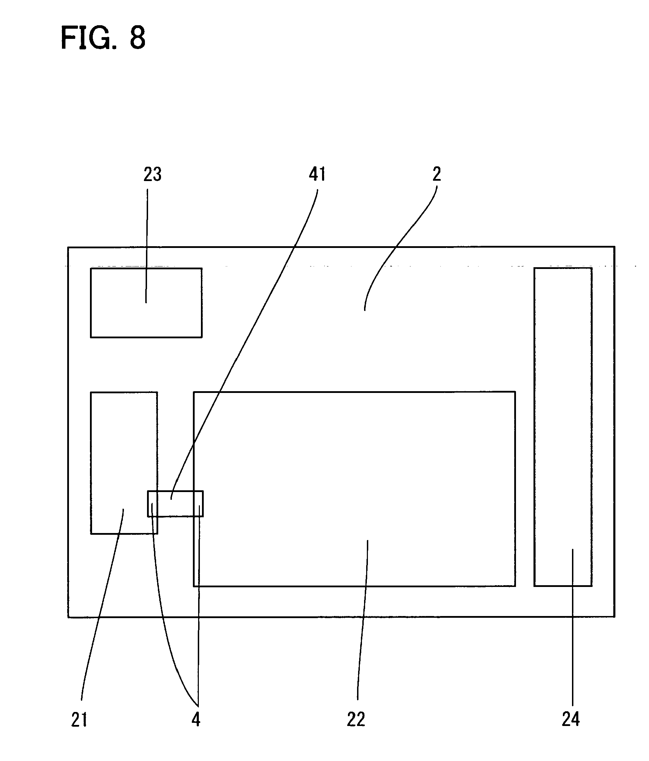

FIG. 8 is a plan view showing a panel inside the display device mounted with the common substrate 21 shown in FIG. 5 and FIG. 6, an AV/POWER substrate 22, a scaling substrate 23 and an inverter substrate 24. Here, the AV/POWER substrate 22 is a substrate which performs analog signal processing such as audio amplification and the scaling substrate 23 is a substrate which performs scaling of videos and the inverter substrate 24 is a substrate which converts an AC voltage supplied from outside to a DC voltage used by the display device. Furthermore, the AV/POWER substrate 22 is mounted with an IC 66 for carrying out analog signal processing. As shown in FIG. 8, when the display device is large and a large panel 2 can be used, the substrates are electrically inter-connected using wire member connectors 4 and a flexible wiring board 41 and the respective substrates are directly mounted on the panel.

As described above, the embodiment of the present invention is adaptable to both the connection method using a board-to-board connector and the connection method using a wire member connector. In this way, it is possible to adapt a substrate on which electronic parts to be shared are gathered to both connection methods and thereby share this substrate regardless of the size of the display device.

As shown in the cross-sectional view in FIG. 9, it is possible to change the distance between the common substrate 21 and AV/POWER substrate 22 by changing the height of the board-to-board connector 3. Therefore, when the IC 66 has a characteristic of producing much noise, it is possible to reduce influences of noise from the IC 66 on the demodulation IC 63 by increasing the distance between the substrates using a higher board-to-board connector 3.

## Claims

1. A substrate mounting method comprising the steps of:
electrically connecting a first substrate and a second substrate which is provided with through holes through which pins of a wire member connector are passed at an end for mounting the wire member connector and lands for mounting a board-to-board connector by soldering pins of the board-to-board connector to the vicinity of the through holes on a surface opposite to the surface on which the wire member connector is mounted; and
mounting the substrates on a display device,
wherein whether to superimpose at least part of the first substrate on the second substrate or separate the first substrate from the second substrate is made selectable according to the size of the display device, and when superimposition of the first substrate on the second substrate is selected, the board-to-board connector is mounted on the first substrate and the second substrate respectively, the first substrate is mounted on the second substrate, and then the board-to-board connector of the second substrate is electrically and physically connected to the board-to-board connector of the first substrate and the second substrate is mounted in an enclosure in such a way that the first substrate and the second substrate are arranged parallel to each other and at least partially overlap each other, and
when separation of the first substrate from the second substrate is selected, the wire member connector is mounted on the first substrate and the second substrate respectively, the pins of the wire member connector passed through the through holes formed in the second substrate and the lands formed in the second substrate are electrically connected using a conductive material, the wire member connector of the first substrate and the wire member connector of the second substrate are electrically connected via a flexible wiring board, and the first substrate and the second substrate are arranged side by side and mounted on the display device.

2. The substrate mounting method according to claim 1, wherein an electronic part which performs digital signal processing is mounted on the second substrate.

3. A display device comprising:
a first substrate; and
a second substrate provided with through holes through which pins of a wire member connector are passed at an end for mounting the wire member connector and lands for mounting a board-to-board connector by soldering pins of the board-to-board connector to the vicinity of the through holes on a surface opposite to the surface on which the wire member connector is mounted,
wherein the board-to-board connector is mounted on the first substrate and the second substrate respectively,
the first substrate is directly mounted on the display device, the board-to-board connector of the second substrate is electrically and physically connected to the board-to-board connector of the first substrate, and
the second substrate is mounted on the display device in such a way that the first substrate and the second substrate are arranged parallel to each other and at least partially overlap each other.

4. A display device comprising:
a first substrate; and
a second substrate provided with through holes through which pins of a wire member connector are passed at an end for mounting the wire member connector and lands for mounting a board-to-board connector by soldering pins of the board-to-board connector to the vicinity of the through holes on a surface opposite to the surface on which the wire member connector is mounted,
wherein the wire member connector is mounted on the first substrate and the second substrate respectively,
the pins of the wire member connector passed through the through holes formed in the second substrate and the lands formed in the second substrate are electrically connected through a conductive material and the wire member connector of the first substrate and the wire member connector of the second substrate are electrically connected via a flexible wiring board, and
the first substrate and the second substrate are arranged side by side and mounted on the display device.

5. The display device according to claim 3 or 4, wherein an electronic part which performs digital signal processing is mounted on the second substrate.

6. A substrate comprising:
through holes through which pins of a wire member connector are passed at an end for mounting the wire member connector; and
lands for mounting a board-to-board connector by soldering pins of the board-to-board connector to the vicinity of the through holes on a surface opposite to the surface on which the wire member connector is mounted,
wherein the pins of the wire member connector are passed through the through holes and the pins of the wire member connector and the lands are electrically connected through a conductive material.

7. The substrate according to claim 6, wherein an electronic part which performs digital signal processing is mounted thereon.
